# EUROPÄISCHE PATENTSCHRIFT

(11) **EP 0 470 420 B1**
(45) Veröffentlichungstag und Bekanntmachung des Hinweises auf die Patenterteilung: **11.05.1994**
(21) Anmeldenummer: 91112210.9
(22) Anmeldetag: 20.07.1991
(51) Int. Cl.: G01B 11/00, G01D 5/34

(54) **Optoelektronische Abtasteinrichtung**
Optoelectronic scanning device
Dispositif du balayage optoélectronique

(30) Priorität: 09.08.1990 DE 9011628 U; 06.04.1991 DE 9104157 U
(43) Veröffentlichungstag der Anmeldung: 12.02.1992
(73) Patentinhaber: hohner ELEKTROTECHNIK KG, D-78532 Tuttlingen (DE)
(72) Erfinder: Riegger, Johannes, W-7200 Tuttlingen (DE); Weber, Karl-Heinz, W-7200 Tuttlingen (DE); Blöchle, Walter, Dipl.-Ing., Sao Paulo (BR)
(74) Vertreter: Patentanwälte Hauck, Graalfs, Wehnert, Döring, Siemons

(56) Entgegenhaltungen:
- DD-A- 272 916
- DE-B- 1 301 916
- FR-A- 2 566 896
- FR-A- 2 588 653
- GB-A- 1 096 022
- GB-A- 2 056 660
- US-A- 4 689 485

## Beschreibung

Die Erfindung bezicht sich auf optoelektronische Abtasteinrichtungen nach den Oberbegriffen der Ansprüche 1 und 7.

Bei bekannten optoelektronischen Winkel-, Rotations- und Wegmeßgeräten tastet ein Lichtstrahl die Codespur eines Codeträgers oder Encoders ab und mißt ein Sensor die Intensitätsänderung des Lichtes durch die Codespur. Bei inkrementalen Meßsystemen werden zur Positionsbestimmung lediglich die Intensitätsänderungen gezählt. Bei Stromausfällen kann dies zum Verlust der Lageinformation führen. Absolute Meßsysteme können hingegen mehrere Codespuren mit verschiedener Codierung aufweisen, die eine Lagebestimmung allein aufgrund der jeweils ermittelten Codeinformation ermöglichen.

Bei diesen optischen Meßanordnungen wird meistens ein Durchlichtverfahren angewendet. Hierbei wird ein Lichtstrahl mittels einer Linse kollimiert und durch ein feststehendes Gitter gesandt. Die Codespur des Codeträgers bildet ein entsprechendes Gitter gleicher Teilung, welches in Strahlendurchgangsrichtung hinter dem feststehenden Gitter beweglich angeordnet ist. Hinter dem Codeträger befinden sich wiederum geeignete Sensoren, die bei deckungsgleicher Ausrichtung der Gitter Lichtdurchgang und bei versetzter Gitterlage Lichtabdunklung messen. Durch Zählen der Übergänge einer Codespur bzw. durch Messen der Informationen paralleler Codespuren kann die zurückgelegte Strecke ermittelt werden. Der Aufwand für die mehreren Gitter ist relativ groß. Außerdem verursachen Beugungs- und andere optische Effekte eine die exakte Messung beeinträchtigende Aufweitung des durchtretenden Lichtstrahles. Eine hohe Auflösung des Gitters ist deshalb nur schwer zu erzielen. Bei absoluten Meßsystemen mit bis zu 24 Spuren bedingt die Strahlaufweitung einen hohen elektronischen Auswerteaufwand. Schließlich sind die teilweise lichtdurchlässigen Codeträger oder Maßstäbe aus Glas bei manchen Anwendungen, insbesondere in der Werkzeugmaschinentechnik, problematisch.

Bekannte optische Datenspeicher weisen eine Codespur auf, die von derselben Seite bestrahlt und gelesen werden. Hierzu wird das Licht einer Lichtquelle mittels einer Linse auf die Codespur fokussiert und das diffus reflektierte Licht nach Passieren derselben Linse durch einen Strahlteiler ausgekoppelt. Diese Technik ist nur für das Lesen einer Codespur geeignet und hinsichtlich der Fokussierung des Lichtstrahles problematisch.

Die FR-A1-2 566 896 offenbart eine optoelektronische Anordnung zum Abtasten von beweglichen Codeträgern, die sich sowohl für das Kollimieren des einfallenden, als auch für das Weiterleiten des durchgestrahlten Lichtes Gradientenindexlinsen bedient. Die weiterleitenden Linsen bündeln das Licht aus Flächenbereichen der Codeträger in optische Fasern hinein, die mit lichtempfindlichen Sensoren verbunden sind. Das erlaubt die integrale Bestimmung der durch das Sichtfeld tretenden Lichtmenge, die sich entsprechend der mit der Wegstrecke veränderlichen Lichtdurchlässigkeit des Codeträgers ändert. Dieser aufwendige Aufbau wirft Justageprobleme auf und arbeitet nicht besonders genau. Außerdem ist sein Platzbedarf wegen der relativ langen Brennweiten und Längsausdehnung des Linsensystems relativ groß.

Aus der DE-OS 34 27 067 ist bereits eine Einrichtung der eingangs genannten Art bekannt, bei der ein codierter Absolutmaßstab über eine Optik abgetastet und auf einen optoelektronischen Zellensensor so abgebildet wird, daß mindestens ein Maßstabstrich und eine Strichcodierung erfaßt werden. Die Auflösung dieser Einrichtung ist nicht besonders hoch, weil jeweils zwischen zwei benachbarten Maßstabsstrichen die Strichcodierung für die absolute Lageinformation angeordnet ist. Außerdem ist die herkömmliche Optik sehr aufwendig und bedingt ebenfalls einen großen Arbeitsabstand.

Davon ausgehend liegt der Erfindung die Aufgabe zugrunde, die optoelektronische Anordnung der eingangs genannten Art so zu verbessern, daß sie mit geringerem Aufwand herstellbar, installierbar und justierbar ist, geringere Abmessungen, insbesondere einen kleineren Arbeitsabstand, aufweist und eine genauere Lageinfor-mation ermöglicht.

Die Lösungen dieser Aufgabe sind in den Ansprüchen 1 und 7 angegeben.

Bei der ersten Lösung wird also der Codeträger mit seiner Codespur in der Objektebene auf der einen Seite der stabförmigen Linse positioniert, so daß diese in einer, in die lichtempfindliche Sensorfläche fallende Bildebene auf ihrer anderen Seite eine maßstabsgetreue Abbildung des Bereichs der Codespur in ihrem Sichtfeld erzeugt. Dabei ist vorteilhaft, daß Linse und Sensor auf der gleichen Seite des Codeträgers angeordnet sind, was eine einfache Installation der Anordnung ermöglicht. Die Anordnung auf nur einer Seite des Codeträgers bedingt auch einen geringeren Aufwand für Ausrichtung und Justage. Die Abbildung der Codespur vermeidet Beugungs- und sonstige nachteilige optische Effekte, womit eine hohe Auflösung einhergeht. Dies macht die Anordnung auch für das Abtasten mehrerer, eng zusammenliegender Codespuren besonders geeignet.

Eine Abbildung der Codespur in den Sensor mittels üblicher Linsen ist wegen des erheblichen Aufwandes für eine genaue Abbildung nicht praktikabel. Erfindungsgemäß ist eine stabförmige Linse vorgesehen, wie sie schon in Druckern für das Abbilden leuchtender Diodenzeilen in einem Abbildungsmaßstab von 1 : 1 auf den Umfang einer Tonertrommel zum Einsatz gekommen sind. Derartige stabförmige Linsen können einen veränderlichen Brechungsindex haben. Dabei kann es sich um sogenannte "Gradientenindexlinsen" handeln.

Bei der alternativen Lösung sorgt eine Mikrolinsenplatte für die ggfs. maßstabsgetreue Abbildung der Codespur in die lichtempfindliche Sensorfläche des optoelektronischen Sensors. Eine Mikrolinsenplatte hat einen plattenförmigen Träger, der mindestens ein zweidimensionales Feld Linsen aufweist. Die Linsen können eine sphärische Kurvatur aufweisen und mittels eines fotothermischen Verfahrens in eine homogene, fotoempfindliche Glasplatte eingearbeitet sein. Die Linsenkurvaturen sind vorzugsweise an entsprechenden Stellen einander gegenüberliegender Plattenseiten angeordnet. Dazwischen können sich undurchsichtige Bereiche befinden. Eine entsprechende Mikrolinsenplatte wird von der Firma Corning Incorporated unter dem eingetragenen Warenzeichen "SMILE" angeboten.

Der Aufwand für eine erfindungsgemäße Einrichtung ist relativ gering, weil Mikrolinsenplatten kostengünstig zur Verfügung stehen. Aufgrund der geringen Dicke der Mikrolinsenplatten von typischerweise 1,4 mm und ihrer kleinen Arbeitsabstände zu Objekt- bzw. Bildebene von z.B. 1,8 mm kann die Einrichtung mit relativ geringen Abmessungen ausgeführt sein. Der geringe Arbeitsabstand ist insbesondere für Winkel- und Rotationsmeßzwecke attraktiv. Infolge der Anordnung der Linsen in Feldern und ihrer gegebenenfalls einander überlappender Sehfelder kann die Einrichtung mit hoher Auflösegenauigkeit arbeiten und eine große Anzahl paralleler Codespuren in einen Sensor abbilden.

Nach einer Ausgestaltung der Erfindung sind mehrere stabförmige Linsen parallel zwischen Codeträger und Sensor angeordnet, wodurch eine Abbildung mehrerer Codespuren in einen Sensor mit lichtempfindlichen Sensorflächen entsprechend den Codespuren begünstigt wird.

Wenn die parallelen Linsen gemäß einer Weiterbildung einander auf dem Codeträger teilweise überlappende Sehfelder haben, wird die Lichtintensität der Abbildung erhöht, weil Überlappungsbereiche in der Objektebene Überlappungsbereichen in der Bildebene entsprechen. Die Abbildungsintensität erhöht sich entsprechend der Anzahl der überlappenden Sehfelder.

Bei einer Fortbildung der Anordnung mit einander überlappenden Sehfeldern der Linsen hat jeweils ein Paar der Linsen eine erste Linse mit einer exzentrischen Einspeisung des Lichtes der Lichtquelle auf der vom Codeträger abgewandten Seite und eine zweite Linse mit einer in entgegengesetzter Richtung exzentrischen Lichtauskopplung in einen Sensor auf der vom Codeträger abgewandten Seite. Das exzentrisch eingespeiste Licht unterliegt in der ersten Linse einer ersten Bildumkehr und wird in den Überlappungsbereich der Sehfelder des Paares projiziert. Das aus dem Überlappungsbereich reflektierte Licht unterliegt in der zweiten Linse einer zweiten Bildumkehr und wird exzentrisch in den Sensor ausgekoppelt. Unmittelbar nebeneinander liegende Linsen können so für die gezielte Lichtein- und Lichtauskopplung genutzt werden. Bei einer Weiterbildung ist zwischen Lichtquelle und Sensor eine Abblendwand angeordnet, die Störeinflüsse auf die Messung verringert.

Eine Ausgestaltung der Erfindung sieht vor, daß die stabförmigen Linsen zu einem Bündel miteinander verbunden sind. Das Linsenbündel ist einfacher fixierbar und justierbar. Außerdem ermöglichst es eine praktisch unterbrechungsfreie Abbildung auch mehrerer Codespuren in eine Bildebene.

Beispielsweise hat die Einrichtung eine Lichtquelle zum Ausleuchten der Codespur, die sich auf der gleichen Seite des Codeträgers wie die Optik befinden kann. Dabei kommen für den Codeträger auch lichtundurchlässige Materialien in Betracht, soweit diese mit einer das Licht reflektierenden Codespur versehen werden können. Diese Anordnung kann jedoch bei einem geringen Arbeitsabstand der Optik problematisch sein. Gemäß einer bevorzugten Ausgestaltung der Erfindung ist deshalb die Lichtquelle auf der vom Sensor abgewandten Seite des Code-trägers angeordnet und durchleuchtet den Codeträger. Dafür wird man meist einen durchscheinenden Codeträger mit einer undurchlässigen Codespur verwenden. Bei dieser Anordnung wird das Ausleuchten der Codespur durch die Optik nicht beeinträchtigt.

Bedingt durch den physikalischen Herstellungsprozeß sind die Linsen bekannter Mikrolinsenplatten aus Glas als einfache sphärische oder halbkugelförmige Linsen ausgebildet. Dies ist mit optischen Nachteilen verbunden. Gemäß einer bevorzugten Ausgestaltung haben die Linsen der Mikrolinsenplatte eine asphärische Kurvatur, wodurch insbesondere die Abbildungsgüte und Lichtstärke der Abbildung verbessert werden.

Mikrolinsenplatten aus Glas haben ferner den Nachteil eines relativ hohen Preises und sind hinsichtlich der Fixierung problematisch. Dafür müssen sie in der Regel in einen besonderen Rahmen eingefaßt werden. Nach einer besonders attraktiven Weiterbildung ist die Mikrolinsenplatte deshalb aus einem Kunststoff hergestellt, insbesondere spritzgegossen. Dieses Herstellungsverfahren ist relativ preisgünstig und ermöglicht auch die Realisierung abweichender Linsenkurvaturen und -halterungen.

Nach einer Fortbildung ist die Mikrolinsenplatte zonenweise mit Mikrolinsenfeldern versehen, die der Detektion von in besonderer Verteilung auf den Codeträger angeordneten Codespuren dienen können. Diese Gestaltungsfreiheit ist insbesondere bei der fotothermischen Herstellungstechnik der Mikrolinsenplatten aus Glas bzw. der Spritztechnik von Kunststoff-Platten gegeben.

Eine Ausgestaltung der Erfindung sieht vor, daß die Kontur der Mikrolinsenplatte zumindest bereichsweise derjenigen des Codeträgers entspricht, insbesondere rechteckig, kreisförmig oder kreisringförmig ist. Hierdurch kann die optisch abtastbare Oberfläche des Code-trägers weitgehend für Codeinformationen genutzt werden.

Wenn der Codeträger mindestens eine optisch abtastbare Referenzspur hat,der Sensor mindestens eine der Referenzspur zugeordnete lichtempfindliche Referenzsensorfläche für die Detektion einer Fehlerausrichtung des Codeträgers zum Sensor aufweist, eine Auswerteeinrichtung zum Umsetzen der Signale jeder Referenzsensorfläche in Steuersignale vorgesehen ist und mindestens ein Stellglied am Sensor angreift, um diesen in Abhängigkeit von den Steuersignalen auf den Codeträger auszurichten, werden Fehlausrichtungen bei der Montage bzw. während des Betriebs durch selbsttätiges Nachstellen des Sensors ausgeglichen. Der Sensor braucht ursprünglich nur grob auf den Codeträger eingestellt zu werden, weil dieser nach Inbetriebnahme dynamisch in eine optimale Lage nachgeführt wird. Fehlausrichtungen infolge betrieblicher Einflüsse, wie ungenauer Führung des Codeträgers, thermischer Ausdehnung oder Abnutzung, werden ohne Nachjustage ausgeglichen. Infolgedessen kann grundsätzlich eine weiter tolerierte, preiswertere Führungsmechanik des Codeträgers verwendet werden.

Abgleichprobleme werden verringert, wenn parallele Referenzspuren und zugeordnete Referenzsensorflächen vorgesehen sind, deren Differenzsignale die Auswerteeinrichtung in Steuersignale umsetzt. Das Vorzeichen des Differenzsignales kann die Richtung der Verschiebung oder Verschwenkung angeben.

Bevorzugt ist mindestens eine Referenzspur und mindestens eine Referenzsensorfläche für die Detektion einer Fehlausrichtung durch Verschiebung in Querrichtung der Referenzspur vorgesehen. Hierfür können zwei Referenzsensorflächen die jeweils zugeordnete Referenzspur in Querrichtung höchstens teilweise erfassen und zwischen ihren einander zugewandten Seiten einen Abstand entsprechend dem Abstand zwischen einander zugewandten Seiten der Referenzspuren voneinander haben. Bei Verschiebung in Querrichtung befindet sich eine Referenzsensorfläche zumindest teilweise außerhalb der zugeordneten Referenzspur, wogegen die andere im Bereich ihrer Referenzspur verbleibt. Dies bewirkt ein besonders deutliches Differenzsignal. Vorzugsweise entspricht der Abstand der beiden Referenzspuren etwa nur der Erstreckung einer Referenzspur in Querrichtung, so daß Fehlausrichtungen durch Verschwenkung der Referenzspuren zum Sensor nur geringen Einfluß auf die zur Verschiebung in Querrichtung gewonnenen Signale haben.

Bevorzugt sind mindestens eine Referenzspur und mindestens eine Referenzsensorfläche für die Detektion einer Fehlausrichtung durch Verschwenkung der Referenzspur zum Sensor vorgesehen. Hierdurch wird ein weiterer Freiheitsgrad der Fehlausrichtung kompensiert. Dafür können zwei Referenzsensorflächen zwischen der Innenseite der jeweils einen und der Außenseite der jeweils anderen Referenzsensorfläche einen Abstand voneinander haben, der dem Abstand zwischen der Innenseite der jeweils einen und der Außenseite der jeweils anderen Referenzspur entspricht. Eine Verschiebung in Querrichtung hat insbesondere bei übereinstimmenden Referenzsensorflächen praktisch keinen Einfluß auf das gemessene Differenzsignal, welches praktisch ausschließlich die Verschwenkung wiedergibt. Wenn die beiden Referenzspuren beidseitig der Codespuren angeordnet sind, bewirken auch kleine Verschwenkungen relativ große Änderungen des Differenzsignales. Bei zwei Paaren paralleler Referenzsensorspuren und Referenzsensorflächen, wovon die Paare Referenzsensorflächen in Richtung der Referenzsensorspuren voneinander versetzt sind, wird die Sicherheit der Detektion weiter verbessert.

Das Stellglied kann eine mikromechanische Vorrichtung sein oder einfach auf der Grundlage eines Piezo-Kristalles realisiert werden.

Weitere Einzelheiten und Vorteile des Gegenstandes der Erfindung ergeben sich aus der nachfolgenden Beschreibung der zugehörigen Zeichnungen, die bevorzugte Ausführungsformen zeigen. In den Zeichnungen zeigen:
- Fig. 1: eine Einrichtung mit einer stabförmigen Linse in perspektivischer Ansicht schräg von oben;
- Fig. 2: eine Einrichtung mit zwei stabförmigen Linsen in perspektivischer Ansicht schräg von oben;
- Fig. 3: eine Einrichtung mit einem Linsenpaket in perspektivischer Ansicht schräg von oben;
- Fig. 4: eine rechteckförmige Mikrolinsenplatte in der Draufsicht;
- Fig. 5: dieselbe Mikrolinsenplatte im Querschnitt;
- Fig. 6: eine halbringförmige Mikrolinsenplatte in der Draufsicht;
- Fig. 7: eine kreisförmige Mikrolinsenplatte in der Draufsicht;
- Fig. 8: eine rechteckförmige Mikrolinsenplatte mit drei zonenweisen Mikrolinsenfeldern in der Draufsicht;
- Fig. 9: eine Mikrolinsenplatte mit identischen Arbeitsabständen zur Objekt- und Bildebene im Querschnitt;
- Fig. 10: eine Mikrolinsenplatte mit identischen, relativ zu Fig. 9 größeren, Arbeitsabständen zur Objekt- und Bildebene im Querschnitt;
- Fig. 11: eine Mikrolinsenplatte mit verschiedenen Arbeitsabständen zur Objekt- und Bildebene im Querschnitt;
- Fig. 12: eine optoelektronische Abtasteinrichtung in einem Drehwinkelgeber im Längsschnitt;
- Fig. 13: einen Ausschnitt eines Codeträgers mit Referenzspuren in der Draufsicht;
- Fig. 14: einen Sensor für den Codeträger gemäß Fig. 13 in der Draufsicht;
- Fig. 15: denselben Sensor auf Referenzspuren ausgerichtet in vergrößerter Draufsicht;
- Fig. 16: optimale Lage der Referenzsensorflächen zu den Referenzspuren in der Draufsicht;
- Fig. 17: Codeträger mit Referenzspuren gegenüber Referenzsensorflächen nach oben verschoben in der Draufsicht;
- Fig. 18: Codeträger mit Referenzspuren gegenüber Referenzsensorflächen nach unten verschoben in der Draufsicht;
- Fig. 19: Codeträger mit Referenzspuren gegenüber Referenzsensorflächen geschwenkt in der Draufsicht;
- Fig. 20: Sensor mit Stellgliedern in der Draufsicht.

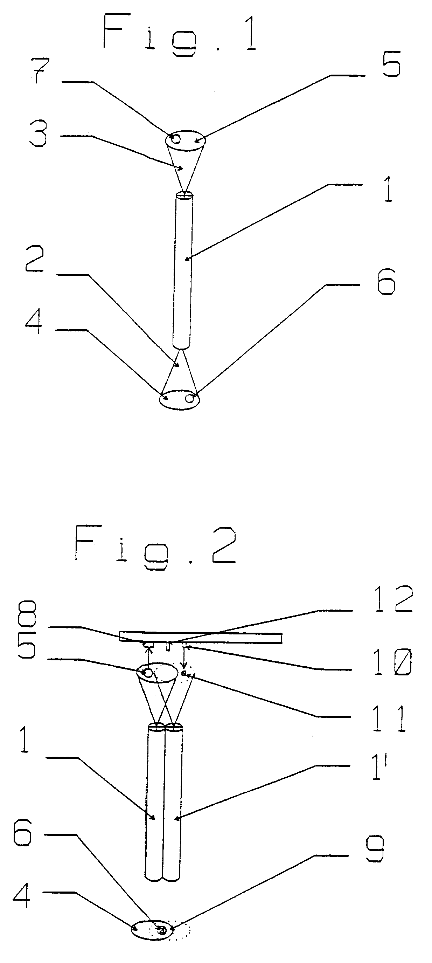

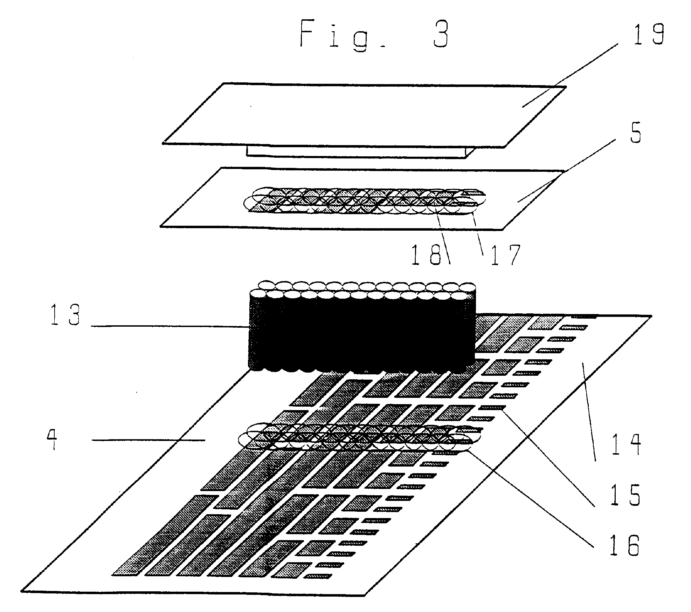

Eine zylinderstabförmige Linse 1 gemäß Fig. 1 hat an beiden Stirnflächen Sehfelder 2, 3, von denen das untere Sehfeld 2 eine Objektebene 4 scharf in eine Bildebene 5 des oberen Sehfeldes 3 abbildet. Ein rechts in der Objektebene 4 befindlicher Punkt 6 wird an der Stelle 7 im Maßstab 1 : 1 in die Bildebene 5 abgebildet, wobei jedoch eine Bildumkehr stattfindet. Das bedeutet, daß sich ein rechts der Mittelachse der Linse 1 in der Objektebene 4 befindlicher Punkt in der Bildebene 5 links abgebildet wird.

Die Bildebene 5 der Anordnung wird auf die Codespur eines - nicht dargestellten - Codeträgers gerichtet, so daß Codeinformationen mittels eines - ebenfalls nicht dargestellten - Sensors gelesen werden können, der sich mit einer lichtempfindlichen Sensorfläche in der Bildebene 5 befindet. Die Beleuchtung erfolgt zweckmäßigerweise von der Linsenseite des Codeträgers aus mittels einer beliebigen Lichtquelle, die in der Fig. 1 ebenfalls nicht abgebildet ist.

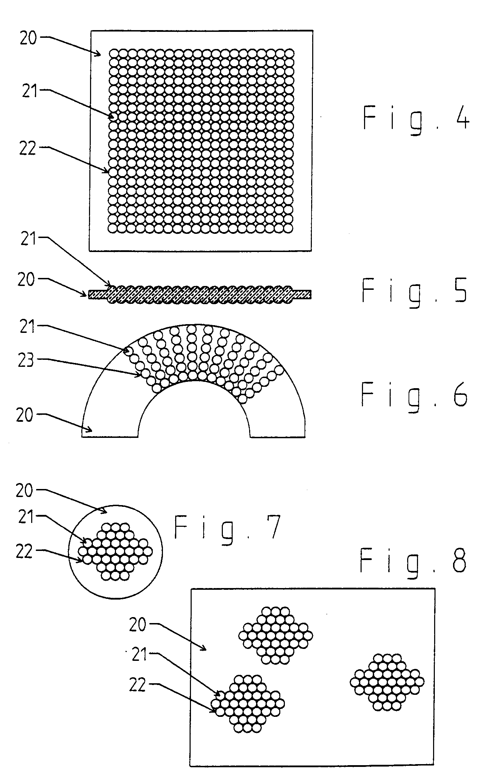

Die Fig. 2 zeigt zwei zylinderstabförmige Linsen 1, 1', wovon die erstgenannte in der zuvor beschriebenen Weise mit einer Objektebene 4 auf einen - nicht dargestellten - Codeträger gerichtet ist, wobei ihre Bildebene 5 in eine lichtempfindliche Fläche eines Sensors 8 fällt. Aus Gründen der Übersichtlichkeit ist der Sensor 8 in einem Abstand von der Bildebene 5 gezeichnet.

Die Linse 1' liegt seitlich an der Linse 1 an und ist parallel zu dieser ausgerichtet. Ihr unteres Sehfeld überlappt sich in einem linsenförmigen Überlappungsbereich 9 in der Objektebene 4 mit dem unteren Sehfeld der Linse 1. Das Licht einer Lichtquelle 10 wird exzentrisch in das obere Sehfeld der Linse 1' eingekoppelt.

Durch die Bildumkehr bedingt gelangt ein Lichtpunkt 11 durch die Linse 1' in den Überlappungsbereich 9. Eine weitere Bildumkehr in der Linse 1 bewirkt, daß das Bild 7 des auf dem Codeträger ausgeleuchteten Punktes 6 exzentrisch aus dem unteren Sehfeld der Linse 1 in den fotoelektrischen Sensor 8 ausgekoppelt werden kann. Somit kann eine Codespur gezielt ausgeleuchtet werden, wobei eine Abblendwand 12 zwischen Sensor 8 und Lichtquelle 10 Störeffekte unterdrückt.

Die Fig. 3 zeigt ein Linsenpaket 13 aus Linsen der zuvor beschriebenen Art mit einem Abbildungsmaßstab von 1 : 1, welches über einem Codeträger 14 angeordnet ist, dessen sieben Codespuren 15 mit verschiedenen Codeinformationen eine absolute Längenmessung ermöglichen. Für eine scharfe Abbildung des Objektes ist das Linsenpaket 13 um einen Basisabstand von der Objektebene 4 beabstandet. In der Objektebene 4 überlappen sich die unteren Sehfelder der benachbarten Linsen des Pakets 13 teilweise, wie dies durch kreisförmige Begrenzungslinien 16 versinnbildlicht wird, von denen jede einer Linse zugeordnet ist.

In der oberhalb des Linsenpakets 13 befindlichen Bildebene 5 werden die durch die Umgrenzungslinien 16 umgrenzten Bereiche des Codeträgers 14 abgebildet, was durch Begrenzungslinien 17 verdeutlicht wird. In den linsenförmigen Überlappungsbereich 18 benachbarter Begrenzungslinien 17 ist der Kontrast zwischen hellen und dunklen Bildbereichen besonders groß.

Ein Fotosensor 19 hat an der Unterseite lichtempfindliche Flächen, die in der Bildebene 5 zu positionieren ist, die sich in einem vorbestimmten Abbildungsabstand von dem Linsenpaket 13 befindet. Aus Gründen der Übersichtlichkeit wurde der Fotosensor 19 jedoch in einem Abstand von der Bildebene 5 gezeichnet. Der Sensor 19 kann in seiner lichtempfindlichen Sensorfläche matrixartig verteilte Sensorelemente haben, die eine Zuordnung der empfangenen Lichtsignale zu den Codespuren 15 des Codeträgers 14 ermöglichen.

Bei den Mikrolinsenplatten gemäß Fig. 4 bis 9 sind die plattenförmigen Träger mit der Bezugsziffer 20 und die darauf ausgebildeten Mikrolinsen mit der Bezugsziffer 21 gekennzeichnet. Die vielfältigen Gestaltungsformen werden durch Herstellung der Mikrolinsenplatten 20 aus Kunststoff begünstigt.

Gemäß Fig. 4 und 5 ist die Mikrolinsenplatte 20 rechteckig und bilden die daran ausgebildeten Mikrolinsen 21 ein entsprechend geformtes Feld 22. Seitlich des Feldes 22 sind Ränder für eine Halterung der Mikrolinsenplatte 20 ausgebildet. Diese Geometrie ist besonders für die Verwendung in Wegmeßgeräten geeignet.

Nach Fig. 6 hat die kreisringabschnittsförmige Mikrolinsenplatte 20 ein Feld 23 aus Mikrolinsen 21, die in Ketten radial nebeneinander angeordnet sind. Diese Anordnung kann z.B. für Winkelmeßgeräte zweckmäßig sein.

Fig. 7 zeigt ein kreuzähnliches Feld 22 aus Mikrolinsen 21 innerhalb der kreisförmigen Mikrolinsenplatte 20. Diese Anordnung kann bei Abtasteinrichtungen für Codeträger zweckmäßig sein, die in zwei zueinander orthogonalen Richtungen bewegt werden.

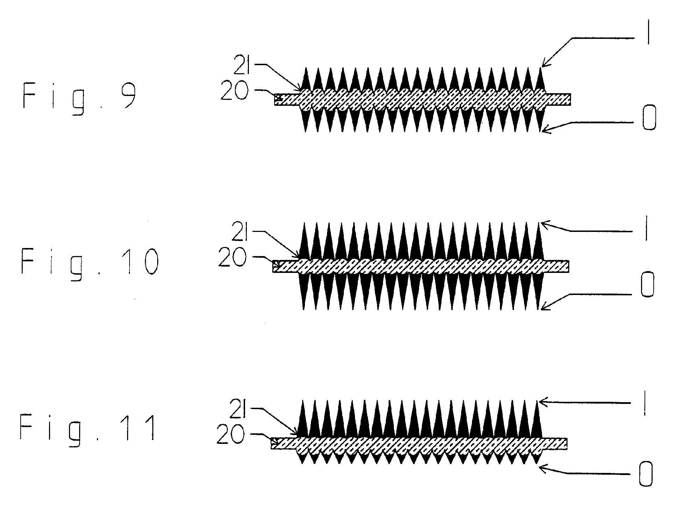

Nach Fig. 8 sind Felder 22 aus Mikrolinsen 21 über verschiedene Stellen verteilt, so daß sie entsprechend voneinander beabstandeten Codespuren eines Codeträgers zugeordnet sein können.

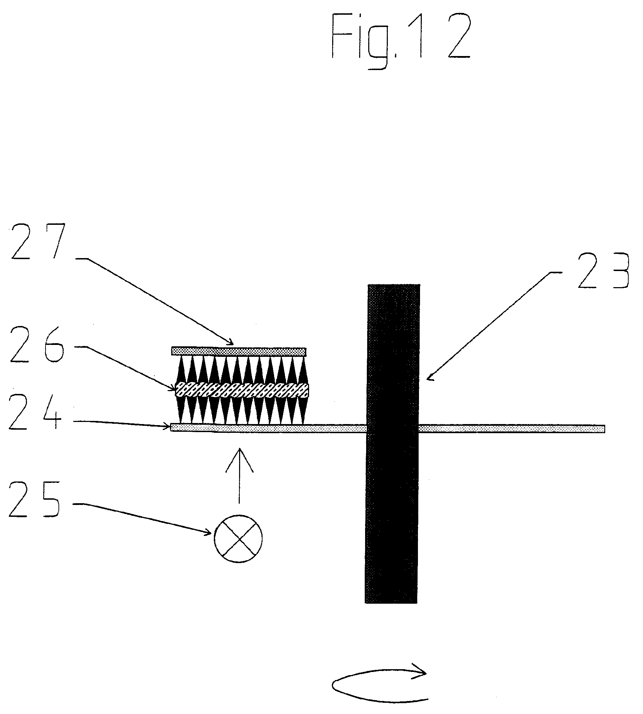

Die Mikrolinsenplatten gemäß Fig. 9 bis 11 haben wiederum eine Platte 20 beliebiger Kontur mit darauf ausgebildeten Mikrolinsen 21, die gemäß Fig. 9 eine beidseitig sphärische, gemäß Fig. 10 eine beidseitig asphärische und gemäß Fig. 11 eine auf der einen Seite asphärische und auf der anderen Seite sphärische Kurvatur aufweisen.

Gemäß Fig. 9 weist die Mikrolinsenplatte gleiche Arbeitsabstände zur Objektebene O und zur Bildebene I auf. Nach Fig. 10 sind die Arbeitsabstände zur Objektebene O bzw. Bildebene I ebenfalls identisch, jedoch größer, als bei der Mikrolinsenplatte aus Fig. 9. Fig. 11 zeigt hingegen asymmetrische Arbeitsabstände, wobei der Abstand zur Objektebene O sehr klein und der zur Bildebene I sehr groß ist.

Fig. 12 zeigt einen Drehwinkelgeber mit einer Welle 23, die dem eingezeichneten Drehpfeil entsprechend um ihrer Längsachse drehbar ist. Die Welle 23 trägt eine Codescheibe 24, welche neben ihrem Außenrand mit Codespuren versehen ist.

Unterhalb der Codescheibe 24 ist eine Lichtquelle 25 angeordnet. Auf der gegenüberliegenden Seite der Codescheibe 24 befindet sich die Mikrolinsenplatte 26, welche die Objektebene im Bereich der Codespuren auf die lichtempfindliche Fläche eines optoelektronischen Sensors 27 abbildet. Die optoelektronische Abtasteinrichtung kann gemeinsam mit der Lichtquelle 25 platzsparend in einem gabelförmigen Gehäuse untergebracht werden, welches unter relativ geringem Montageaufwand auf die Codescheibe 24 ausgerichtet werden kann.

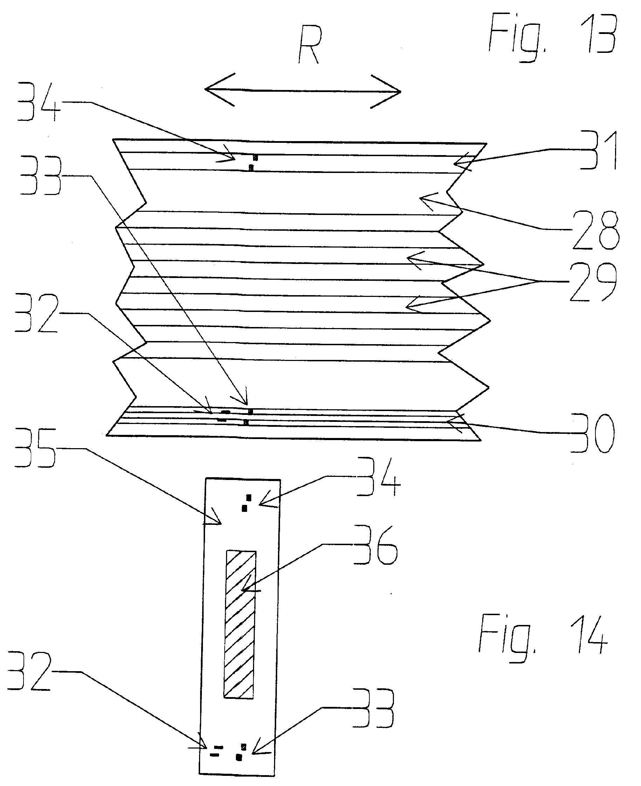

Für einen automatischen Ausgleich von Fehlausrichtungen zwischen Sensor und Codeträger 28 hat letzterer gemäß Fig. 13 auf jeder Seite seiner Codespuren 29 ein Paar Referenzspuren 30, 31. Dem Codeträger 28 ist die Bewegungsrichtung gemäß Doppelpfeil R zugedacht. Lichtempfindliche Referenzsensorflächen 32, 33, 34 des Sensors erfassen Fehlausrichtungen und sind zur Veranschaulichung in Fig. 13 eingetragen.

Gemäß Fig. 14 ist der Sensor 35 unterseitig mit einer Sensorfläche 36 zur Detektion der Informationen in den Codespuren 29 ausgestattet. Beidseitig davon befinden sich die Referenzsensorflächen 32, 33 und 34.

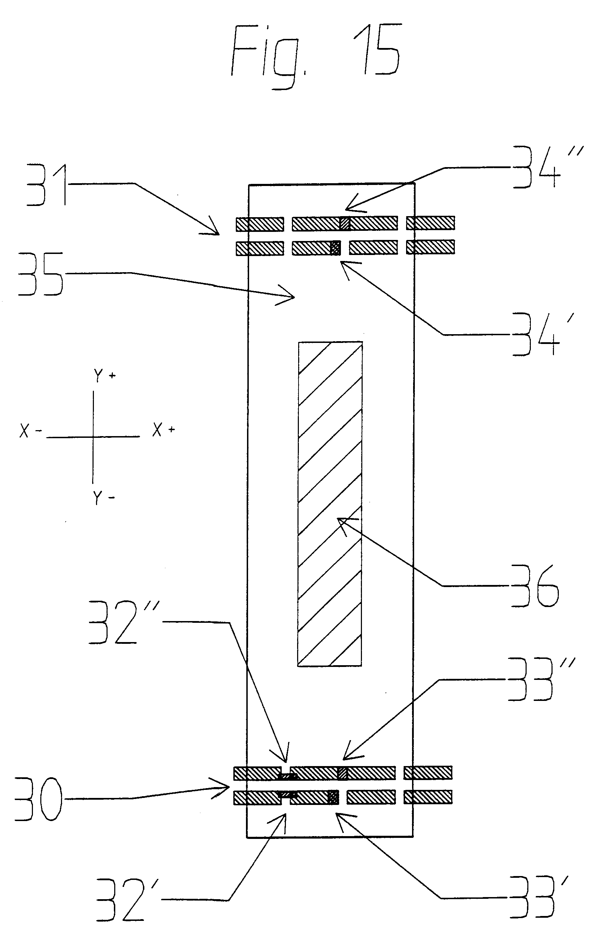

Die Fig. 15 zeigt, daß der Sensor 35 bei optimaler Ausrichtung auf den Codeträger mit seinen Referenzsensorflächen 32', 32'', 33', 33'', 34', 34'' bündig mit Seiten der beiden Paare Referenzspuren 30, 31 abschließt. Die Referenzsensorflächen 32', 32'' dienen der Detektion von Fehlausrichtungen in y+ und y- -Richtungen, wogegen die Referenzsensorflächen 33', 33'' und 34', 34'' der Detektion von Verschwenkungen der Referenzspuren 30, 31 zum Sensor 35 dienen.

Vorstehendes kann besser anhand der Fig. 16 bis 19 verstanden werden, die in Fig. 16 nochmals die optimale Ausrichtung der Referenzsensorflächen 32, 33, 34 auf die Referenzspuren 30, 31 zeigen.

Die Fig. 17 und 18 demonstrieren, daß bei Fehlausrichtung des Codeträgers 35 in y+ Richtung nach oben der Referenzsensor 32'' außerhalb der oberen des Paares Referenzspuren 30 angeordnet ist, wogegen bei Verschiebung des Codeträgers 35 nach unten der Referenzsensor 32' außerhalb der unteren des Paares Referenzspuren 30 gelangt. Dies gründet sich darauf, daß die Referenzsensorflächen 32 bei optimaler Ausrichtung (Fig. 16) mit den Innenseiten der Referenzspuren 30 fluchten und in Querrichtung der Referenzspuren 30 eine diese unterschreitende Ausdehnung (ungefähr ein Drittel) haben. Die Signale der Referenzsensorflächen 32', 32'' werden von einer Auswerteeinrichtung in ein Differenzsignal umgesetzt, das geringe Abgleichprobleme aufwirft und dem Abstand von der optimalen Lage proportional ist. Wie die Fig. 17 und 18 ferner zeigen, ergeben sich durch die Verschiebung keine unterschiedlichen Signale zwischen den Paaren Referenzsensorflächen 33 und 34.

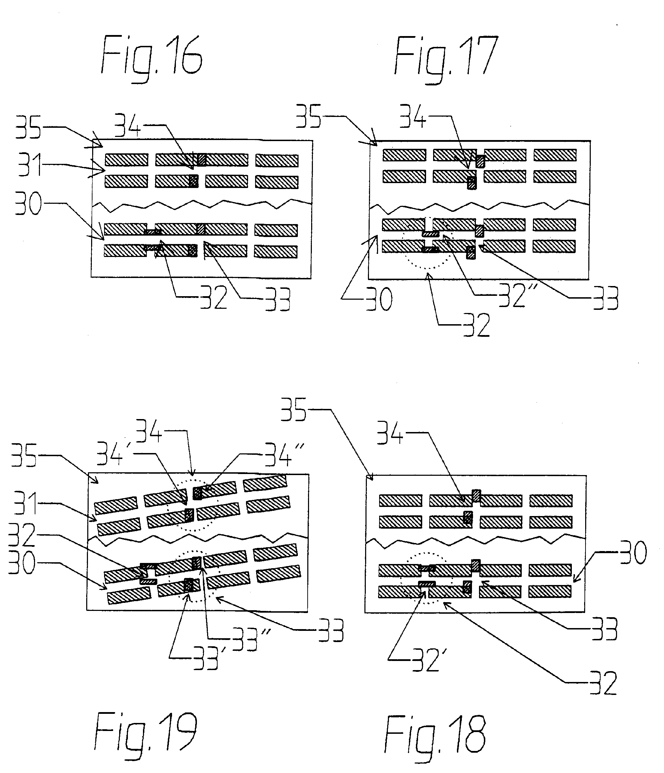

Die Fig. 19 zeigt jedoch, daß eine Verschwenkung des Codeträgers 35 zum Sensor vor allem Unterschiede in den Signalen der Paare Referenzsensorflächen 33, 34 bewirkt. Die Referenzspuren 30, 31 sind in regelmäßigen Abständen unterbrochen, so daß die normalerweise beidseitig mit den Referenzspuren fluchtenden Referenzsensorflächen 33, 34 nicht nur verschieden über Seiten der Referenzspuren 30, 31, sondern auch in Zwischenräume verschiedener Referenzspurenelemente eintreten. Die Differenzsignale der Referenzsensorflächen 33', 34' und 33'', 34'' können wiederum von der Auswerteeinrichtung ermittelt und als Maß für den Grad der Verschwenkung in ein Steuersignal für die Korrektur der Fehlausrichtung umgesetzt werden.

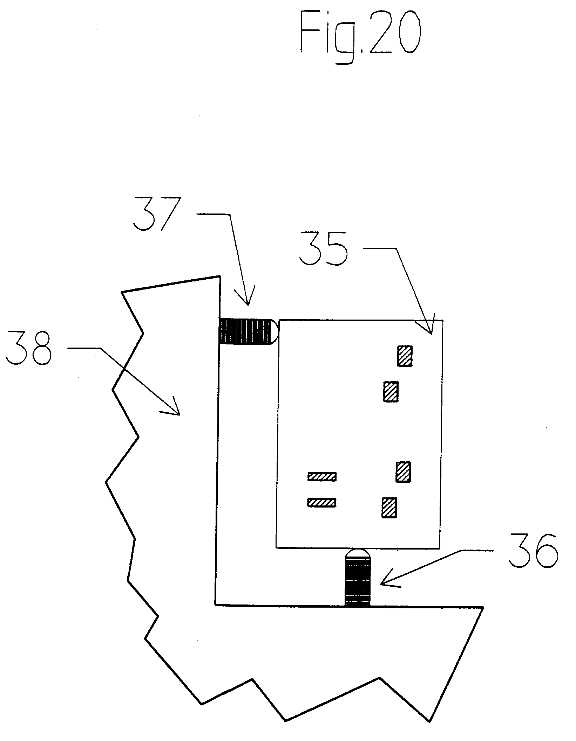

Gemäß Fig. 20 ist der Sensor 35 über Stellglieder 36, 37 mit einem Gehäuse oder Rahmen 38 abgestützt. Der Rahmen 38 dient als Bezugspunkt für Korrekturen, die durch Zuführen von Steuersignalen an die Stellglieder 36, 37 ausgeführt werden und den Sensor 35 zwecks Kompensation von Verschiebungen und Verschwenkungen korrekt auf den Codeträger ausrichten. Das Stellglied 36 dient der Kompensation von Verschiebungen, wogegen das Stellglied 37 Verkippungen ausgleicht. Eine Anlage an den balligen Endflächen der Stellglieder 36, 37 kann durch Federdruck auf den Sensor 35 bewirkt werden. Die Stellglieder 36, 37 haben Piezo-Kristalle.

Diese Art der Korrektur von Fehlausrichtung ist besonders für die erfindungsgemäß verwendeten stabförmigen Linsen bzw. Mikrolinsenplatten geeignet, weil diese abbildenden Systeme grundsätzlich den Bewegungen von Codeträger und Sensor nicht folgen müssen, soweit der Codeträger mit seinen Code- und Referenzspuren nur im Sehfeld der Optik verbleibt.

## Patentansprüche

1. Optoelektronische Abtasteinrichtung, insbesondere für Weg-, Winkel- und Rotationsmeßgeräte sowie optische Speicher, mit einem beleuchteten oder durchleuchteten Codeträger (5), wenigstens einer optisch abtastbaren Codespur auf dem Codeträger, einer die Codespur erfassenden Optik (7) und einem optoelektronischen Sensor (8), in dessen lichtempfindliche Sensorfläche die Optik die Codespur abbildet, dadurch gekennzeichnet, daß die Optik mindestens eine stabförmige Linse (1, 1', 13) ist.

2. Einrichtung nach Anspruch 1, dadurch gekennzeichnet,daß mehrere stabförmige Linsen (1, 1', 13) parallel zueinander zwischen Codeträger (14) und Sensor (8, 19) angeordnet sind.

3. Einrichtung nach Anspruch 2, dadurch gekennzeichnet,daß die parallelen Linsen (1, 1', 13) einander auf dem Codeträger (14) teilweise überlappende Sehfelder (2) haben.

4. Einrichtung nach Anspruch 3, dadurch gekennzeichnet,daß jeweils ein Paar der Linsen (1, 1') eine erste Linse (1') mit einer exzentrischen Einspeisung des Lichtes der Lichtquelle (10) auf der vom Codeträger abgewandten Seite und eine zweite Linse (1) mit einer in entgegengesetzter Richtung exzentrischen Lichtauskopplung in einen Sensor (8) auf der vom Codeträger abgewandten Seite hat.

5. Einrichtung nach Anspruch 4, dadurch gekennzeichnet, daß eine Abblendwand (12) zwischen Lichtquelle (10) und Sensor (8) angeordnet ist.

6. Einrichtung nach einem der Ansprüche 2 bis 5, dadurch gekennzeichnet, daß die stabförmigen Linsen (1, 1', 13) zu einem Bündel miteinander verbunden sind.

7. Einrichtung nach dem Oberbegriff des Anspruches 1, dadurch gekennzeichnet, daß die Optik eine Mikrolinsenplatte (7) ist.

8. Einrichtung nach einem der Ansprüche 1 bis 7, dadurch gekennzeichnet, daß eine Lichtquelle (6) auf der vom Sensor (8) abgewandten Seite des Codeträgers (5) angeordnet ist und den Codeträger durchleuchtet.

9. Einrichtung nach Anspruch 7 oder 8, dadurch gekennzeichnet, daß die Linsen (2) der Mikrolinsenplatte (7) eine asphärische Kurvatur haben.

10. Einrichtung nach einem der Ansprüche 7 bis 9, dadurch gekennzeichnet,daß die Mikrolinsenplatte (7) aus einem Kunststoff hergestellt, insbesondere spritzgegossen ist.

11. Einrichtung nach einem der Ansprüche 7 bis 10, dadurch gekennzeichnet, daß die Mikrolinsenplatte zonenweise mit Mikrolinsenfeldern (3) versehen ist.

12. Einrichtung nach einem der Ansprüche 7 bis 11, dadurch gekennzeichnet, daß die Kontur der Mikrolinsenplatte zumindest bereichsweise derjenigen des Codeträgers entspricht, insbesondere rechteckig, kreisförmig oder kreisringförmig ist.

13. Einrichtung nach einem der Ansprüche 1 bis 12, dadurch gekennzeichnet, daß der Codeträger (28) mindestens eine optisch abtastbare Referenzspur (30, 31) hat, der Sensor (35) mindestens eine der Referenzspur zugeordnete lichtempfindliche Referenzsensorfläche (32, 33, 34) für die Detektion einer Fehlausrichtung des Codeträgers zum Sensor aufweist, eine Auswerteeinrichtung zum Umsetzen der Signale jeder Referenzsensorfläche (32, 33, 34) in Steuersignale vorgesehen ist und mindestens ein Stellglied (36, 37) am Sensor (35) angreift, um diesen in Abhängigkeit von den Steuersignalen auf den Codeträger (28) auszurichten.

14. Einrichtung nach Anspruch 13, dadurch gekennzeichnet, daß parallele Referenzspuren (30, 31) und zugeordnete Referenzsensorflächen (32, 33, 34) vorgesehen sind, deren Differenzsignale die Auswerteeinrichtung in Steuersignale umsetzt.

15. Einrichtung nach Anspruch 13 oder 14, dadurch gekennzeichnet, daß mindestens eine Referenzspur (30) und mindestens eine Referenzsensorfläche (32', 32'') für die Detektion einer Fehlausrichtung durch Verschiebung in Querrichtung der Referenzspur (30) vorgesehen sind.

16. Einrichtung nach Anspruch 14 und 15, dadurch gekennzeichnet, daß zwei Referenzsensorflächen (32', 32'') die jeweils zugeordnete Referenzspur (30) in Querrichtung höchstens teilweise erfassen und zwischen ihren einander zugewandten Seiten einen Abstand entsprechend dem Abstand zwischen den einander zugewandten Seiten der Referenzspuren (30) voneinander haben.

17. Einrichtung nach Anspruch 16, dadurch gekennzeichnet, daß der Abstand der beiden Referenzspuren (30) etwa der Erstreckung einer Referenzspur in Querrichtung entspricht.

18. Einrichtung nach einem der Ansprüche 13 bis 17,dadurch gekennzeichnet, daß mindestens eine Referenzspur (30, 31) und mindestens eine Referenzsensorfläche (33, 34) für die Detektion einer Fehlausrichtung durch Verschwenkung der Referenzspur zum Sensor (35) vorgesehen sind.

19. Einrichtung nach Anspruch 14 und 18, dadurch gekennzeichnet, daß zwei Referenzsensorflächen (33', 34'; 33'', 34'') zwischen der Innenseite der jeweils einen und der Außenseite der jeweils anderen Referenzsensorfläche einen Abstand voneinander haben, der dem Abstand zwischen der Innenseite der jeweils einen und der Außenseite der jeweils anderen Referenzspur (30, 31) entspricht.

20. Einrichtung nach Anspruch 19, dadurch gekennzeichnet, daß die beiden Referenzspuren (30, 31) beidseitig der Codespuren (29) angeordnet sind.

21. Einrichtung nach Anspruch 19 oder 20, dadurch gekennzeichnet, daß zwei Paare paralleler Referenzspuren (30, 31) und Referenzsensorflächen (33', 34'; 33'', 34'') vorgesehen sind, wovon die Paare Referenzsensorflächen in Richtung der Referenzspuren voneinander versetzt sind.

22. Einrichtung nach einem der Ansprüche 13 bis 21,dadurch gekennzeichnet, daß das Stellglied (36, 37) einen Piezo-Kristall aufweist.

## Claims

1. An optoelectronic scanning device particularly for position-, angle- and rotation-measuring instruments as well as optical storages comprising an illuminated or transilluminated code carrier (5), at least one optically scannable code track on said code carrier, a lens adapted to reproduce said code track, and an optoelectronic sensor (8), on the light-sensitive sensor surface of which said code track is reproduced by said lens, characterized in that said lens comprises at least one rod-shaped lens (1, 1', 13).

2. The scanning device according to claim 1, characterized in that a plurality of rod-shaped lenses (1, 1', 13) are arranged parallel to each other between said code carrier (14) and said sensor (8, 19).

3. The scanning device according to claim 2, characterized in that said parallel lenses (1, 1', 13) have partly overlapping fields of vision (2) on said code carrier (14).

4. The scanning device according to claim 3, characterized in that each pair of said lenses (1, 1') comprises a first lens (1') in which the light of the light source (10) is eccentrically fed on the side opposed to said code carrier, and a second lens (1) in which the light which has the contrary direction with respect to the fed-in light is eccentrically balanced out towards a sensor (8) on the side opposed to said code carrier.

5. The scanning device according to claim 4, characterized in that a screening wall (12) is placed between said light source (10) and said sensor (8).

6. The scanning device according to any of claims 2 to 5, characterized in that said rod-shaped lenses (1, 1', 13) are interconnected and define a bundle.

7. The scanning device according to the preamble of the claim 1, characterized in that said lens comprises a micro-lens plate .

8. The scanning device according to any of the claims 1 to 7, characterized in that a light source (6) is located on the side of said code carrier (5) which is opposed to said sensor (8) and transilluminates said code carrier.

9. The scanning device according to claim 7 or 8, characterized in that said lenses (2) of said micro-lens plate have an aspheric curvature.

10. The scanning device according to any of the claims 7 to 9, characterized in that said micro-lens plate is made of plastic, especially die-casted.

11. The scanning device according to any of the claims 7 to 10, characterized in that said micro-lens plate comprises micro-lens fields (3) which are arranged in zones.

12. The scanning device according to any of the claims 7 to 11, characterized in that the contour of said micro-lens plate at least partially corresponds to the contour of said code carrier, with the contour of said plate being especially rectangular, circular or ring-shaped.

13. The scanning device according to any of the claims 1 to 12, characterized in that said code carrier (28) has at least one optically scannable reference track (30, 31), said sensor (35) comprises at least one light-sensitive reference sensor surface (32, 33, 34) associated with said reference track, for the detection of a misalignment of said code carrier to said sensor, an evaluation unit is provided for transforming said signals of each reference sensor surface (32, 33, 34) in control signals, and at least one positioning element (36, 37) engages said sensor (35) to adjust said sensor to said code carrier (28) in dependence on said control signals.

14. The scanning device according to claim 13, characterized in that parallel reference tracks (30, 31) and associated reference sensor surfaces (32, 33,34) are provided, the differential signals thereof being transformed in said control signals by said evaluation unit.

15. The scanning device according to claim 13 or 14, characterized in that at least one reference track (30) and at least one reference sensor surface (32', 32'') are provided for the detection of a misalignment developed by a crosswise displacement of said reference track (30).

16. The scanning device according to claims 14 and 15, characterized in that two reference sensor surfaces (32', 32'') at best partly record each of the associated reference tracks (30) in transverse direction with the distance between the faced sides of said reference sensor surfaces corresponding to the distance between the faced sides of said reference tracks (30).

17. The scanning device according to claim 16, characterized in that the distance between both reference tracks (30) approximately corresponds to the dimension of a reference track in transverse direction.

18. The scanning device according to any of the claims 13 to 17, characterized in that at least one reference track (30, 31) and at least one reference sensor surface (33, 34) are provided for the detection of a misalignment developed by a tilt of said reference track to said sensor (35).

19. The scanning device according to claims 14 and 18, characterized in that the distance between said two reference sensor surfaces (33', 34'; 33'', 34'') from the inner surface of one reference sensor surface to the outer surface of the other reference sensor surface corresponds to the distance from the inner surface of one reference track to the outer surface of the other reference track (30, 31).

20. The scanning device according to claim 19, characterized in that said two reference tracks (30, 31) are located on both sides of the code tracks (29).

21. The scanning device according to claim 19 or 20, characterized in that two pairs of parallel reference tracks (30, 31) and reference sensor surfaces (33', 34'; 33'', 34'') are provided, with said pairs of reference sensor surfaces being displaced from each other with respect to the direction of said reference tracks.

22. The scanning device according to any of the claims 13 to 21, characterized in that said positioning element (36, 37) comprises a piezo-crystal.

## Revendications

1. Dispositif de balayage optoélectronique, notamment destiné à des appareils de mesure de déplacements, d'angles, et de rotations, ainsi qu'à des mémoires optiques, comprenant un support de code (5) éclairé ou illuminé par transparence, au moins une piste de codage susceptible d'être balayée de manière optique prévue sur le support de code, une optique qui lit la piste de codage, et un détecteur optoélectronique (8), sur la surface de détection, sensible à la lumière, duquel l'optique forme l'image de la trace de codage,
caractérisé en ce que l'optique est constituée par au moins une lentille (1, 1', 13) en forme de barreau.

2. Dispositif selon la revendication 1, caractérisé en ce que plusieurs lentilles (1, 1', 13) en forme de barreau sont disposées parallèlement les unes aux autres, entre le support de code (14) et le détecteur (8, 19).

3. Dispositif selon la revendication 2, caractérisé en ce que les lentilles parallèles (1, 1', 13) présentent des champs optiques (2) se chevauchant partiellement sur le support de code (14).

4. Dispositif selon la revendication 3, caractérisé en ce qu'une paire de lentilles (1, 1') comprend chaque fois une première lentille (1') présentant une entrée excentrée pour la lumière de la source lumineuse (10), sur le côté opposé à celui qui fait face au support de code, et une seconde lentille (1) présentant un découplage de lumière, excentré dans la direction opposée, vers un détecteur (8) situé sur le côté opposé à celui faisant face au support de code.

5. Dispositif selon la revendication 4, caractérisé en ce qu'une paroi formant écran (12) est disposée entre la source lumineuse (10) et le détecteur (8).

6. Dispositif selon l'une des revendications 2 à 5, caractérisé en ce que les lentilles (1, 1', 13) en forme de barreau sont reliées les unes aux autres en un faisceau.

7. Dispositif selon le préambule de la revendication 1, caractérisé en ce que l'optique est une plaque à micro-lentilles.

8. Dispositif selon l'une des revendications 1 à 7, caractérisé en ce qu'une source lumineuse (6) est disposée sur le côté du support de code (5) opposé à celui faisant face au détecteur (8), et éclaire le support de code par transparence.

9. Dispositif selon la revendication 7 ou 8, caractérisé en ce que les lentilles (2) de la plaque à micro-lentilles présentent une courbure non sphérique.

10. Dispositif selon l'une des revendications 7 à 9, caractérisé en ce que la plaque à micro-lentilles est fabriquée en une matière plastique, notamment moulée par injection.

11. Dispositif selon l'une des revendications 7 à 10, caractérisé en ce que la plaque à micro-lentilles est pourvue par zones, de champs de micro-lentilles (3).

12. Dispositif selon l'une des revendications 7 à 11, caractérisé en ce que le contour de la plaque à micro-lentilles correspond au moins partiellement, à celui du support de code, et est notamment rectangulaire, circulaire ou en forme d'anneau circulaire.

13. Dispositif selon l'une des revendications 1 à 12, caractérisé en ce que le support de code (28) comporte au moins une piste de référence (30, 31) pouvant être balayée de manière optique, en ce que le détecteur (35) comporte au moins une surface de détection de référence (32, 33, 34) sensible à la lumière, associée à la piste de référence et destinée à la détection d'un défaut d'orientation du support de code par rapport au détecteur, en ce qu'est prévu un dispositif de traitement de données pour convertir les signaux de chaque surface de détection de référence (32, 33, 34) en signaux de commande, et en ce qu'au moins un organe de réglage (36, 37) agit sur le détecteur (35) en vue d'orienter celui-ci par rapport au support de code (28), en fonction des signaux de commande.

14. Dispositif selon la revendication 13, caractérisé en ce que sont prévues des pistes de référence parallèles (30, 31) et des surfaces de détection de référence (32, 33, 34) associées, dont les signaux de différence sont convertis en signaux de commande par le dispositif de traitement de données.

15. Dispositif selon la revendication 13 ou 14, caractérisé en ce qu'au moins une piste de référence (30) et au moins une surface de détection de référence (32', 32'') sont prévues pour la détection d'un défaut d'orientation par translation dans la direction transversale de la trace de référence (30).

16. Dispositif selon les revendications 14 et 15, caractérisé en ce que deux surfaces de détection de référence (32', 32'') couvrent au plus partiellement, dans la direction transversale, la piste de référence (30) respectivement associée, et présentent entre leurs côtés se faisant face, une distance égale à la distance entre les côtés se faisant face, des pistes de référence (30).

17. Dispositif selon la revendication 16, caractérisé en ce que la distance entre les deux pistes de référence (30) correspond environ à l'étendue d'une piste de référence dans la direction transversale.

18. Dispositif selon l'une des revendications 13 à 17, caractérisé en ce qu'au moins une piste de référence (30, 31)) et au moins une surface de détection de référence (33, 34) sont prévues pour la détection d'un défaut d'orientation par pivotement de la trace de référence par rapport au détecteur (35).

19. Dispositif selon les revendications 14 et 18, caractérisé en ce que deux surfaces de détection de référence (33', 34'; 33'', 34'') présentent, entre le côté intérieur de l'une et le côté extérieur de l'autre surface de détection de référence, une distance correspondant à la distance entre le côté intérieur de l'une et le côté extérieur de l'autre des pistes de référence respectives (30, 31).

20. Dispositif selon la revendication 19, caractérisé en ce que les deux pistes de référence (30, 31) sont disposées de part et d'autre des pistes de codage (29).

21. Dispositif selon la revendication 19 ou 20, caractérisé en ce que sont prévues deux paires de pistes de référence (30, 31) et de surfaces de détection de référence (33', 34'; 33'', 34'') parallèles, dont les paires de surfaces de détection de référence sont décalées l'une par rapport à l'autre dans la direction des pistes de référence.

22. Dispositif selon l'une des revendications 13 à 21, caractérisé en ce que l'organe de réglage (36, 37) comporte un cristal piézoélectrique.
